# DEMANDE DE BREVET EUROPEEN

(11) **EP 1 634 685 A2**
(43) Date de publication de la demande: **15.03.2006**
(21) Numéro de dépôt: 05108398.8
(22) Date de dépôt: 13.09.2005
(51) Int. Cl.: B29C 33/42, C03B 11/08, H01L 27/13

(54) **Puce mince en verre pour composant électronique et procédé de fabrication**

(30) Priorité: 14.09.2004 FR 0452039
(71) Demandeur: ST MICROELECTRONICS S.A., 92120 Montrouge (FR)
(72) Inventeur: Gardes, Pascal, 37100, TOURS (FR); Guitton, Fabrice, 37380, MONNAIE (FR)
(74) Mandataire: de Beaumont, Michel

(57) **Abrégé**

L'invention concerne la fabrication de composants électroniques (6) sur des substrats individuels en matériau isolant (53), et consiste à : mouler, dans une plaquette de silicium (1), un matériau isolant (5) dans une épaisseur correspondant à l'épaisseur finale souhaitée pour lesdits substrats ; fabriquer les composants électroniques ; et éliminer le silicium depuis la face arrière de la plaquette après fabrication desdits composants.

## Description

### Domaine de l'invention

La présente invention concerne la fabrication de composants électroniques sur des plaquettes servant de substrat et, plus particulièrement, les produits dits simple face, c'est-à-dire dont les composants ne sont portés que par une seule face de la plaquette.

L'invention s'applique plus particulièrement à la fabrication de composants passifs sur des substrats en verre.

### Exposé de l'art antérieur

Les souhaits de miniaturisation des composants s'accompagnent d'un besoin de réduire l'épaisseur des plaquettes ou substrats supportant ces composants. La faible épaisseur recherchée pour les composants finis est toutefois incompatible avec la contrainte subie par les plaquettes lors de la fabrication, et l'épaisseur finale du substrat individuel du composant est par conséquent atteinte en fin de procédé.

Dans l'exemple d'application de l'invention à la réalisation de composants passifs sur des substrats en verre, les composants sont réalisées sur une face, dite arbitrairement avant, d'une plaquette en verre relativement épaisse (plus de 500 micromètres). Puis, la plaquette est meulée par sa face arrière dépourvue de composant jusqu'à atteindre l'épaisseur finale souhaitée pour les substrats individuels (200 micromètres voire moins).

En sortie de réduction d'épaisseur, la plaquette perd considérablement de sa résistance mécanique. Or, les manipulations requises lors d'étapes suivantes, entre autres de nettoyage et de rinçage, entraînent des risques de fissures ou ruptures des structures des composants réalisés en face avant.

On notera que le risque de casse de la structure intervient déjà lors de l'étape de rectification en raison de l'appui irrégulier de la face avant qui porte les composants. La différence de planéité de la face avant est typiquement de l'ordre d'une vingtaine de micromètres (variation d'épaisseur de la face avant en fin de fabrication des composants). L'appui irrégulier qui en découle, associé à la pression appliquée par la meule en face arrière, entraîne des risques de casse, surtout en fin d'étape de rectification lorsque la plaquette devient de plus en plus mince et que la différence de planéité n'est plus négligeable devant l'épaisseur globale de la plaquette. C'est notamment pourquoi les épaisseurs finales des plaquettes, rectifiées en face arrière après fabrication des composants, ne sont généralement pas inférieures à 200 micromètres.

Un autre inconvénient est lié à une déformation de la plaquette qui devient légèrement bombée (warp) quand elle est fine. Cette déformation provient notamment de la présence de composants sur une seule face. Cette courbure peut empêcher les plaquettes d'être logées dans des paniers de traitement par lot. A titre d'exemple, avec une flèche atteignant 3,2 millimètres, l'introduction des plaquettes fines dans les paniers habituels de manipulation n'est plus possible.

### Résumé de l'invention

La présente invention vise à supprimer le risque entraîné par la manipulation de plaquettes fines, notamment en verre, en fin de procédé de fabrication de composants électroniques et plus particulièrement de composants réalisés sur une seule face avec des traitements épais ou contraignants susceptibles d'engendrer des défauts de planéité de surface de la plaquette.

La présente invention vise également à proposer une solution permettant d'atteindre des épaisseurs finales plus fines sans risque de casse de la plaquette. L'invention vise notamment à atteindre des épaisseurs inférieures à 100 µm.

L'invention vise également à proposer une solution particulièrement adaptée à des substrats en verre.

L'invention vise également une solution plus particulièrement adaptée à la fabrication de composants passifs sur des substrats en verre.

Pour atteindre ces objets ainsi que d'autres, la présente invention prévoit un procédé de fabrication de composants électroniques sur des substrats individuels en matériau isolant, consistant à :
mouler, dans une plaquette de silicium, un matériau isolant dans une épaisseur correspondant à l'épaisseur finale souhaitée pour lesdits substrats ;
fabriquer les composants électroniques ; et
éliminer le silicium depuis la face arrière de la plaquette après fabrication desdits composants.

Selon un mode de mise en oeuvre de la présente invention, la face avant de la plaquette de silicium est gravée pour recevoir le matériau isolant par moulage, selon un motif de disque destiné à porter plusieurs composants, une étape de découpe du matériau isolant étant réalisée après élimination du silicium en face arrière.

Selon un mode de mise en oeuvre de la présente invention, la face avant de la plaquette de silicium est gravée pour recevoir le matériau isolant par moulage, selon des motifs correspondant aux motifs des substrats individuels des composants à réaliser.

Selon un mode de mise en oeuvre de la présente invention, le silicium subsistant entre les motifs de gravure définit des chemins de découpe ultérieure.

Selon un mode de mise en oeuvre de la présente invention, les composants sont individualisés par attaque chimique de l'intégralité du silicium à l'issue de la fabrication des composants.

Selon un mode de mise en oeuvre de la présente invention, l'épaisseur du matériau isolant encastré dans la plaquette de silicium est inférieure à 100 µm.

Selon un mode de mise en oeuvre de la présente invention, le matériau isolant est du verre.

L'invention prévoit également un composant électronique réalisé sur un substrat isolant.

Selon un mode de réalisation de la présente invention, la surface périphérique du substrat isolant présente un état irrégulier, sans éclats.

Selon un mode de réalisation de la présente invention, le composant comprend plusieurs éléments passifs.

### Brève description des dessins

Ces objets, caractéristiques et avantages, ainsi que d'autres de la présente invention seront exposés en détail dans la description suivante de modes de mise en oeuvre et de réalisation particuliers faite à titre non-limitatif en relation avec les figures jointes parmi lesquelles .
Les figures 1A à 1G illustrent, de façon très schématique et par des vues en coupe, un premier mode de mise en oeuvre du procédé de fabrication de composants portés par des substrats en verre selon la présente invention ;
les figures 2A et 2B sont des vues schématiques de dessus d'une plaquette à l'issue des étapes illustrées par les figures 1A à 1G ;
les figures 3A et 3B sont des vues schématiques respectives en coupe et de dessus d'une puce de composant passif selon la présente invention ;
les figures 4A à 4D illustrent, par des vues en coupe schématiques, un deuxième mode de mise en oeuvre préféré du procédé de fabrication de composants sur substrats en verre selon la présente invention ;
les figures 5A et 5B sont des vues schématiques de dessus d'une plaquette à l'issue des étapes des figures 4A et 4B ;
les figures 6A et 6B représentent, respectivement vue de dessus et en coupe, une puce de composant(s) sur substrat en verre selon une variante du deuxième mode de mise en oeuvre ; et
les figures 7A et 7B représentent, respectivement vue de dessus et en coupe, une puce de composant(s) sur substrat en verre selon le deuxième mode de mise en oeuvre préféré de l'invention.

Les mêmes éléments ont été désignés par les mêmes références aux différentes figures qui ont été tracées sans respect d'échelle. Pour des raisons de clarté, seules les étapes de procédé qui sont nécessaires à la compréhension de l'invention ont été représentées aux figures et seront décrites par la suite. En particulier, les étapes de fabrication proprement dites des composants sur la face avant d'une plaquette traitée par l'invention (dépôts de couches, définitions de motifs, gravures, etc.) n'ont pas été détaillées, l'invention étant compatible avec les étapes classiques de fabrication de composants électroniques, notamment de composants passifs.

### Description détaillée

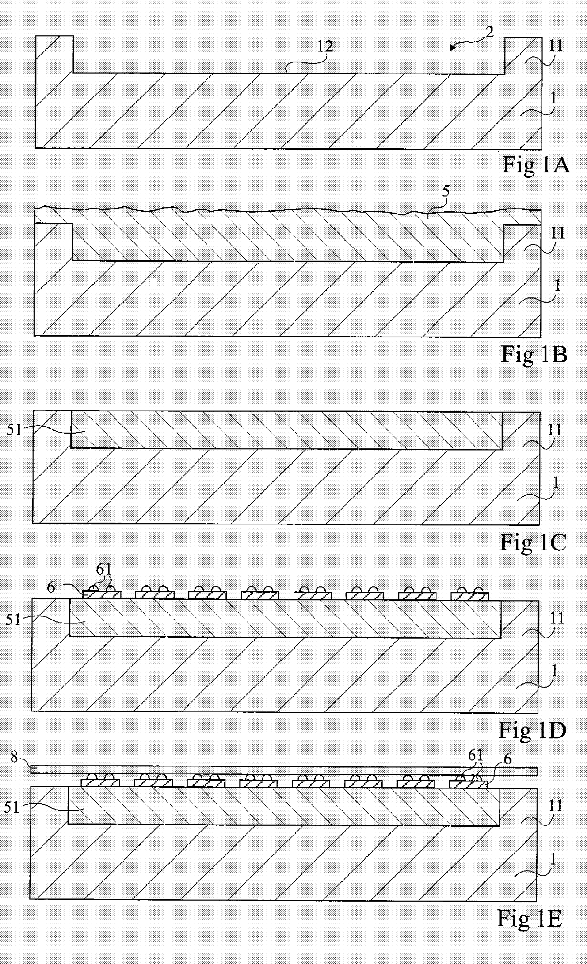

Les figures 1A à 1G illustrent, par des vues en coupe schématiques, un premier mode de mise en oeuvre du procédé de fabrication de composants passifs sur substrats isolants, de préférence en verre, selon la présente invention.

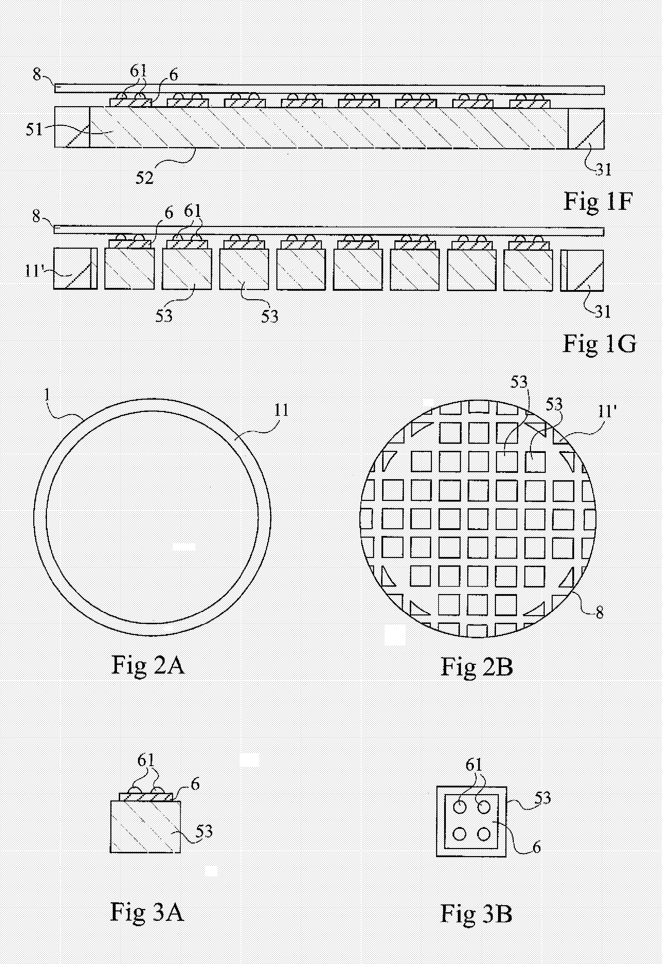

On part d'une plaquette de silicium 1 (ou autre matériau habituellement utilisé comme substrat dans l'industrie électronique, de préférence, de faible coût). On réalise, dans la plaquette 1, une gravure, de préférence circulaire, de façon à obtenir un mur périphérique 11 en silicium entourant le fond 12 en forme de disque de la gravure réalisée. La figure 2A représente une vue de dessus de cette structure.

Selon l'invention, la profondeur de la cavité obtenue 2 est choisie pour correspondre (au moins approximativement) à l'épaisseur finale souhaitée pour les substrats de verre devant porter les composants réalisés en face avant. Par exemple, la profondeur de la gravure est comprise entre 20 et 100 µm alors que l'épaisseur totale de la plaquette 1 est initialement supérieure à la profondeur gravée (par exemple, 500 µm).

Le rôle de la plaquette 1 est, selon l'invention, de fournir la rigidité mécanique nécessaire aux manipulations de l'ensemble pendant les étapes de fabrication des composants. Son épaisseur n'est pas critique dans la mesure où elle ne sert que de support.

Dans une deuxième étape (figure 1B), on remplit la cavité 2 avec du verre 5. Par exemple, ce remplissage est obtenu en posant une plaquette de verre sur la plaquette 1 de silicium et en faisant fondre cette plaquette de verre, de façon à remplir le motif gravé dans la plaquette 1. Selon un autre exemple, le remplissage est effectué avec de la poudre de verre avec ou sans liant.

Selon un autre mode de mise en oeuvre, le matériau de remplissage n'est pas du verre mais un autre matériau isolant. Tout matériau isolant convient, pourvu qu'il soit adapté à un remplissage de la cavité et à constituer un substrat pour les composants.

Dans une troisième étape (figure 1C), on réalise une rectification de la face avant de la plaquette de façon à obtenir une surface plane adaptée à la fabrication ultérieure des composants. Cette rectification est, par exemple, effectuée jusqu'à atteindre le dessus du mur périphérique 11 en silicium. En variante, le meulage pourra attaquer légèrement ce mur.

La structure issue de l'étape représentée en figure 1C est celle qui sert de base à la fabrication des composants sur la face avant de la plaquette. Cette structure se compose d'un disque 51 en verre encastré dans la plaquette 1 de silicium.

L'ensemble des étapes de fabrication des composants est effectué par des procédés classiques. En particulier, l'invention est compatible avec les températures utilisées habituellement pour réaliser des composants sur une plaquette en verre.

On obtient alors (figure 1D) une plaquette sur laquelle ont été réalisés des composants 6 répartis sur le disque en verre 51, toujours encastré dans la plaquette de silicium 1. De préférence, la fabrication des composants 6 va jusqu'à la réalisation de bossages conducteurs 61 ou équivalents qui seront utilisés par la suite pour connecter le ou les composants 6 sur un circuit imprimé ou analogue. Le nombre de composants individuels (résistance, inductance, condensateur) réalisés sur une même puce dépend de l'application et le nombre de bossages dépend également de l'application (des besoins de connexion du ou des composants réalisés).

Selon l'invention, on rapporte (figure 1E) sur la face avant de la plaquette un disque 8 de protection, par exemple que l'on colle sur la face avant de la structure. L'utilisation de disques de protection de composants est en elle-même classique.

On réalise alors (figure 1F) un amincissement de la face arrière de la plaquette 1 de façon à éliminer le support de silicium. Cette diminution d'épaisseur depuis la face arrière est effectuée jusqu'à atteindre la face arrière 52 du disque en verre 51.

Différentes méthodes de réduction d'épaisseur peuvent être utilisées. Par exemple, on pourra effectuer une attaque du silicium par plasma, par meulage, ou par un procédé de gravure humide pourvu que la gravure n'attaque pas les composants formés sur la face avant. En variante, cette face avant pourra être protégée par une couche adaptée (par exemple, en résine) déposée avant la pose du disque de protection et avant la gravure de la face arrière.

Parmi les matériaux de gravure préférés, on notera l'utilisation possible de NH₄OH qui présente l'avantage de ne pas attaquer les composants passifs réalisés sur le verre.

Puis (figure 1G), les composants sont individualisés par une découpe du disque en verre 51 depuis sa face arrière 52. En variante, le disque 51 est transféré sur un disque de protection en face arrière, puis le disque de protection de la face avant est retiré pour effectuer une découpe depuis la face avant. La découpe d'une plaquette en verre est en elle-même classique. On obtient les composants individuels portés par des substrats en verre respectifs 53 qu'il ne reste plus qu'à décoller du disque de protection 8.

La figure 2B illustre une vue de dessous de la structure obtenue à l'issue de l'étape de découpe. En figure 2B, on a supposé que des résidus 11' du mur périphérique de silicium restent attachés au disque 8.

Pour décoller le disque 8 de protection, on rapporte (par exemple par collage) un autre disque (non représenté) sur la face arrière afin de tenir, lors du décollage du disque de protection 8 en face avant, les composants réalisés. Le disque 8 n'a pas nécessairement une forte adhérence. Toutefois, il doit être compatible avec la technique utilisée pour diminuer l'épaisseur de la face arrière, en particulier dans le cas d'une gravure chimique.

Les figures 3A et 3B représentent, respectivement en coupe et vu de dessus, un exemple de puce 6 de composant (s) passif(s) portés sur un substrat de verre 53, obtenu par la mise en oeuvre du procédé de l'invention.

Un avantage de l'invention est qu'elle permet de réaliser l'ensemble des étapes de fabrication non seulement des composants eux-mêmes mais également des substrats de verre de faible épaisseur par plaquettes entières.

Un autre avantage de la présente invention est que les manipulations des substrats sont facilitées grâce à la tenue mécanique assurée par la plaquette de silicium 1.

Un autre avantage de l'invention est que son procédé de fabrication est compatible avec les techniques habituellement utilisées pour réaliser des composants sur des plaquettes en verre. En particulier, l'invention est particulièrement adaptée à la réalisation de composants passifs (RLC) sur des substrats en verre.

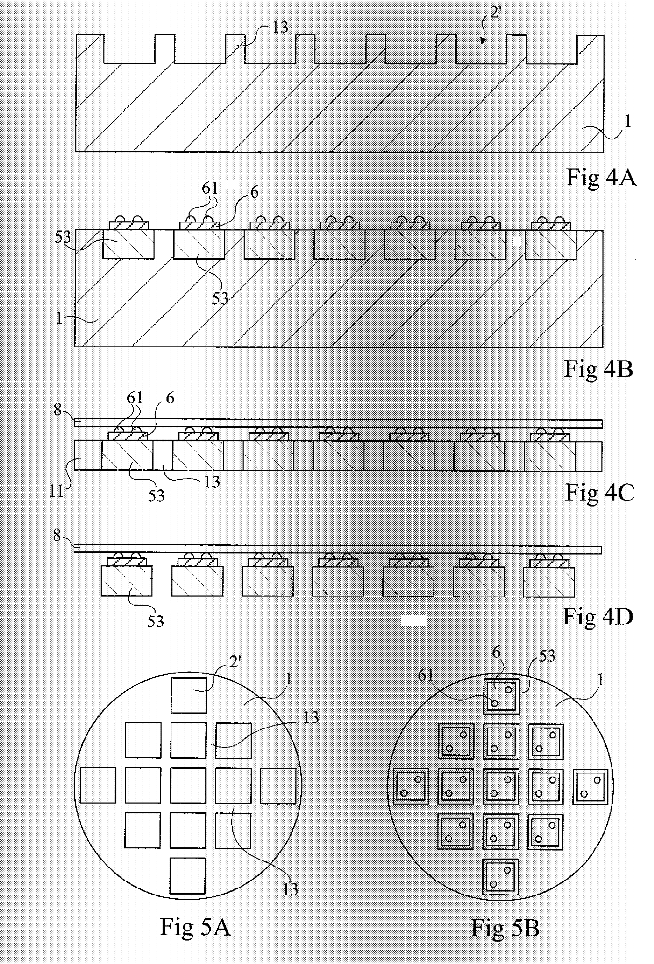

Les figures 4A à 4D illustrent, par des vues en coupe, des étapes d'un deuxième mode de mise en oeuvre préféré du procédé de l'invention. Certaines étapes sont identiques à celles décrites en relation avec le premier mode de mise en oeuvre et n'ont pas été représentées.

On part toujours (figure 4A) d'une plaquette 1 de silicium ou analogue destinée à servir de support mécanique pour la fabrication des composants sur des substrats en verre. Toutefois, à la différence du premier mode de réalisation, le motif de gravure 2' depuis la face avant de la plaquette 1 n'est pas celui d'un disque mais directement celui souhaité pour les substrats individuels de verre (53, figure 3) portant les composants. Ainsi, des poutres 13 de silicium restent présentes entre les zones 2' gravées. Comme dans le premier mode de mise en oeuvre, la profondeur de gravure est choisie pour correspondre à l'épaisseur finale souhaitée pour les substrats de verre.

La figure 5A est une vue de dessus de la plaquette de silicium 1 de la figure 4A.

On dépose ensuite du verre dans les motifs 2' gravés dans la plaquette de silicium 1 comme dans le premier mode de mise en oeuvre (figure 1B).

Puis, on effectue une rectification de la face avant de l'ensemble jusqu'à atteindre le silicium 1 de façon à obtenir une surface plane, à la manière du premier mode de mise en oeuvre (figure 1C).

On réalise ensuite de façon classique les composants 6 et éventuellement leurs bossages de raccordement 61, et l'on obtient une structure telle que représentée en figure 4B dans laquelle des composants 6, portés par des substrats individuels en verre 53, se retrouvent encastrés dans la plaquette de silicium 1.

La figure 5B est une vue de dessus de la structure obtenue à l'issue de la fabrication des composants (figure 4B).

Comme dans le premier mode de mise en oeuvre (figure 1E), on rapporte alors un disque de protection 8 de la face avant.

On effectue ensuite une attaque du silicium depuis sa face arrière, au moins jusqu'à atteindre les substrats de verre 53 (figure 4C). Subsistent alors autour des substrats de verre 53, la périphérie de la plaquette ainsi que les poutres 13 séparant les substrats.

Selon un mode de mise en oeuvre préféré de l'invention, l'attaque chimique du silicium est poursuivie jusqu'à éliminer l'intégralité du silicium, donc les poutres 13 et la périphérie. On obtient alors directement une structure telle qu'illustrée dans la figure 4D où les puces sont attachées par leurs faces avant au disque de protection 8. Il ne reste plus qu'à détacher le disque 8, comme précédemment en utilisant un deuxième disque que l'on colle sur la face arrière des substrats 53.

En variante, à l'issue de l'attaque du silicium jusqu'à la face arrière des substrats 53, on effectue une découpe de la plaquette dans des chemins définis par les poutres de silicium 13. Un avantage par rapport au premier mode de mise en oeuvre où la découpe s'effectue dans le verre, est qu'une découpe dans le silicium s'effectue de façon plus fine et sans éclat de verre. Cette variante du deuxième mode de mise en oeuvre est utilisée, par exemple, si l'attaque de la face arrière du silicium s'effectue par rectification (meulage).

Un avantage du mode de mise en oeuvre préféré est qu'il supprime toute étape de découpe au moyen d'un outil de type scie ou analogue.

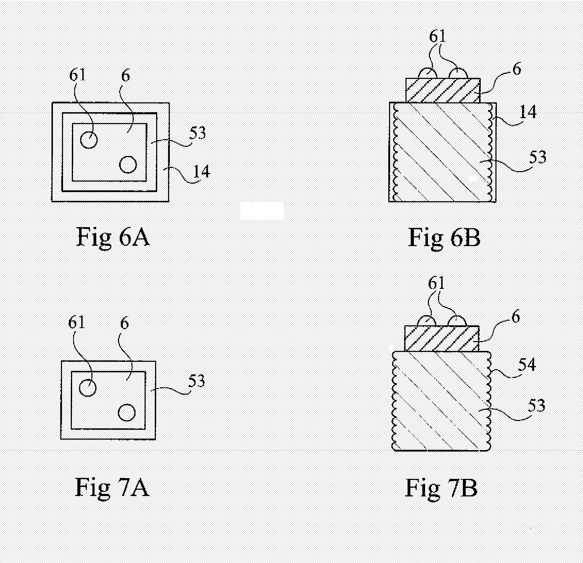

Les figures 6A et 6B représentent, respectivement vu de dessus et en coupe, une puce en verre 53 portant un ou plusieurs composants 6 (par exemple, des composants passifs) issue de la variante du deuxième mode de mise en oeuvre. On voit que la puce de verre 53 est entourée d'une épaisseur de silicium 14 provenant des restes de la découpe dans la plaquette 1.

En coupe (figure 6B), l'interface de séparation entre le verre 53 et le silicium 14 présente un aspect dentelé (scalloping) qui provient du procédé utilisé pour graver le silicium (étape de la figure 4A) qui ne permet l'obtention d'un état de surface verticale parfait. Lors de la fusion du verre pour réaliser les substrats 53, celui-ci remplit donc les aspérités existantes.

Les figures 7A et 7B représentent, respectivement vu de dessus et en coupe, une puce de verre portant un ou plusieurs composants (de préférence passifs) obtenus par le deuxième mode de mise en oeuvre préféré de l'invention. On retrouve une structure similaire à celle des figures 6A à 6B à l'exception du fait que le substrat de verre 53 n'est pas entouré de silicium. Les parois verticales du substrat 53 présentent alors directement un état de surface 54 irrégulier provenant du moulage du verre dans les motifs gravés de silicium.

Un avantage d'une attaque chimique du silicium depuis la face arrière de la plaquette 1 est que la face arrière des puces en verre 53 présente alors un état de surface dépourvu de rayures, contrairement au meulage qui crée des rayures sur la surface attaquée.

Bien entendu, la présente invention est susceptible de diverses variantes et modifications qui apparaîtront à l'homme de l'art. En particulier, l'adaptation de l'épaisseur de gravure dans la plaquette de silicium qui dépend de l'épaisseur finale souhaitée pour les substrats de verre est à adapter en fonction de l'application. On notera que, en théorie, il n'y a pas d'épaisseur minimale. On peut ainsi réaliser des composants notamment passifs portés par des substrats en verre très fins (par exemple d'une ou quelques dizaines de micromètres).

De plus, la mise en oeuvre pratique de l'invention en utilisant des techniques habituelles dans le domaine de la microélectronique est à la portée de l'homme du métier à partir des indications fonctionnelles données ci-dessus.

## Revendications

1. Procédé de fabrication de composants électroniques (6) sur des substrats individuels en matériau isolant (53), **caractérisé en ce qu'**il consiste à :
mouler, dans une plaquette de silicium (1), un matériau isolant (5) dans une épaisseur correspondant à l'épaisseur finale souhaitée pour lesdits substrats ;
fabriquer les composants électroniques ; et
éliminer le silicium depuis la face arrière de la plaquette après fabrication desdits composants.

2. Procédé selon la revendication 1, dans lequel la face avant de la plaquette de silicium (1) est gravée pour recevoir le matériau isolant (5) par moulage, selon un motif (2) de disque (51) destiné à porter plusieurs composants (6), une étape de découpe du matériau isolant étant réalisée après élimination du silicium en face arrière.

3. Procédé selon la revendication 1, dans lequel la face avant de la plaquette de silicium (1) est gravée pour recevoir le matériau isolant (5) par moulage, selon des motifs (2') correspondant aux motifs des substrats individuels (53) des composants (6) à réaliser.

4. Procédé selon la revendication 3, dans lequel le silicium (13) subsistant entre les motifs de gravure (2') définit des chemins de découpe ultérieure.

5. Procédé selon la revendication 3, dans lequel les composants (6) sont individualisés par attaque chimique de l'intégralité du silicium (1) à l'issue de la fabrication des composants.

6. Procédé selon la revendication 1, dans lequel l'épaisseur du matériau isolant (5, 53) encastré dans la plaquette de silicium (1) est inférieure à 100 µm.

7. Procédé selon la revendication 1, dans lequel le matériau isolant est du verre.

8. Composant électronique (6) réalisé sur un substrat isolant (53) par la mise en oeuvre du procédé selon l'une quelconque des revendications 1 à 7.

9. Composant selon la revendication 8, dans lequel la surface périphérique du substrat isolant (53) présente un état irrégulier (54), sans éclats.

10. Composant selon la revendication 8, comprenant plusieurs éléments passifs.
